# DEMANDE DE BREVET EUROPEEN

(11) **EP 1 686 391 A1**
(43) Date de publication de la demande: **02.08.2006**
(21) Numéro de dépôt: 06290106.1
(22) Date de dépôt: 17.01.2006
(51) Int. Cl.: G01R 31/36

(54) **Procédé d'évaluation du fonctionnement d'une batterie pour véhicule automobile**

(30) Priorité: 28.01.2005 FR 0500876
(71) Demandeur: VALEO EQUIPEMENTS ELECTRIQUES MOTEUR, 94017 Creteil Cedex (FR)
(72) Inventeur: Soucaze-Guillous, Benoit, 94017 Creteil Cedex (FR); Greco, Marco, 94017 Creteil Cedex (FR)

(57) **Abrégé**

L'invention concerne un procédé d'évaluation de la capacité d'une batterie pour véhicule automobile à répondre à un fonctionnement déterminé, ledit véhicule comprenant un moteur thermique, une machine électrique tournante destinée à entraîner ledit moteur thermique. L'invention se caractérise en ce que ledit procédé comprend les étapes de, lors d'une première période de temps déterminée :
- évaluer au moins une vitesse de rotation de ladite machine électrique tournante,
- établir au moins une variable d'état d'usure selon une fonction de ladite vitesse de rotation, et
- comparer ladite au moins variable d'état à au moins une variable d'état nominale.

## Description

### Domaine de l'invention

L'invention concerne un procédé d'évaluation de la capacité d'une unité de stockage pour véhicule automobile à répondre à un fonctionnement déterminé, ledit véhicule comprenant un moteur thermique, une machine électrique tournante destinée à entraîner ledit moteur thermique, ainsi qu'un dispositif d'évaluation de la capacité d'une batterie à répondre à un fonctionnement déterminé. L'invention trouve des applications notamment dans le domaine de l'industrie automobile et, en particulier, dans le domaine des alternateurs et alterno-démarreurs.

### Etat de la technique

De nombreux procédés d'évaluation ont été proposés pour connaître l'état de fonctionnement d'une unité de stockage telle qu'une batterie. Une batterie est caractérisée entre autre par sa résistance interne. Si cette résistance interne est trop élevée, le véhicule peut ne pas démarrer. Cela signifie que la batterie est trop vieille ou qu'elle ne fournit plus assez de puissance ou encore d'énergie pour remplir la fonction de démarrage. Cette résistance interne dépend notamment de deux paramètres qui sont :
- l'état de charge de la batterie bien connue de l'homme du métier appelée couramment SOC (« State Of Charge » en anglais), et
- la température de la batterie.

De manière générale, plus la température de la batterie baisse, plus la résistance interne de la batterie augmente. De la même manière, en général plus l'état de charge de la batterie diminue, plus sa résistance interne augmente.

Le but de ces divers procédés est de connaître l'évolution de cette résistance interne de manière à connaître l'état de fonctionnement d'une batterie, en particulier le point de démarrage ou non-démarrage du véhicule selon l'état de la batterie ou encore l'état de vieillissement de la batterie.

Ainsi, selon un premier état de la technique US 65 349 92, un procédé d'analyse de l'état de fonctionnement d'une batterie est décrit. Il se base sur le fait que la variation de tension aux bornes de la batterie lors d'un démarrage est une image de la résistance interne de ladite batterie. Ainsi, il utilise la tension mesurée aux bornes de la batterie pour déterminer un profil de démarrage du véhicule. La tension mesurée au cours du temps est analysée par la suite afin de connaître l'état de fonctionnement de la batterie.

Selon un deuxième état de la technique FR2 831 670, un procédé de diagnostic de la batterie est décrit. Il se base sur le fait que le nombre de tours moteurs sur entraînement du démarreur est une image de la résistance interne de la batterie. Il calcule une température de non-démarrage à partir de la valeur du nombre de tours moteur au passage de la seconde compression du moteur thermique. Par ailleurs, il utilise une courbe de référence en prenant comme base une température minimale de -20°C pour 100 tours/min.

Le premier état de la technique présente un inconvénient selon lequel il est nécessaire d'avoir des capteurs de tension sur la batterie. Afin de récupérer les informations tension, il est nécessaire de passer par des câbles et une connectique batterie. Ces capteurs représentent un inconvénient en raison des problèmes de compatibilité électromagnétiques, lesdits problèmes peuvent entraîner des perturbations sur l'information tension ou des pertes de cette information. Un passage d'une information analogique (via des câbles) à une information digitale (de type PWM) entraîne une étape supplémentaire et un surcoût économique.

Le deuxième état de la technique présente un inconvénient selon lequel en raison du point de référence utilisé, il est nécessaire de calibrer le gestionnaire de batterie en fonction du moteur du constructeur qui est intégré dans le véhicule.

### Exposé de l'invention

Aussi, un problème technique à résoudre par l'objet de la présente invention est de proposer un procédé d'évaluation de la capacité d'une unité de stockage pour véhicule automobile à répondre à un fonctionnement déterminé, ledit véhicule comprenant un moteur thermique, une machine électrique tournante destinée à entraîner ledit moteur thermique, ainsi qu'un dispositif d'évaluation associé, qui permettent d'obtenir une évaluation précise de la capacité de fonctionnement d'une batterie pour un état de fonctionnement déterminé.

Une solution au problème technique posé consiste, selon un premier objet de la présente invention, en ce que le procédé comprend les étapes de, lors d'une période de temps déterminée :
- évaluer au moins une vitesse de rotation de ladite machine électrique tournante,
- établir au moins une variable d'état d'usure selon une fonction de ladite vitesse de rotation, et
- comparer ladite au moins variable d'état à au moins une variable d'état nominale.

Ainsi, comme on le verra en détail plus loin, la vitesse de rotation de ladite machine est une image de la résistance interne de la batterie. Grâce à cette vitesse de rotation, on peut établir un profil de fonctionnement type de la batterie puis établir un fonctionnement au cours du temps de la batterie et en déduire un état d'usure de la batterie.

Selon des modes de réalisation préférentiels non limitatifs, le procédé objet de l'invention présente les caractéristiques supplémentaires énoncées ci-après.

Ladite variable d'état nominale est définie lors d'une période de temps antérieure à la première période de temps. Ainsi, on définit un profil de fonctionnement type de la batterie, ce profil servant de référence lors de l'évaluation du fonctionnement de la batterie par la suite.

Le procédé comporte en outre les étapes de :
- évaluer la capacité de la batterie selon une fonction basée sur la comparaison entre une variable d'état d'usure et une variable d'état nominale, ladite fonction dépendant dudit fonctionnement déterminé, et
- envoyer un signal de contrôle à un organe de gestion du véhicule représentatif de ladite évaluation.

Ainsi, un utilisateur du véhicule est informé s'il doit changer sa batterie avant que ledit véhicule ne tombe en panne.

Un vecteur de variables d'état d'usure est défini selon les étapes dudit procédé. Ainsi, on définit plusieurs variables d'état tout le long de la vie de la batterie.

Un vecteur de vitesses de rotation est défini, lesdites vitesses étant déterminées en fonction d'une température de la batterie, ladite température évoluant lors de la première période de temps. La température est en effet un paramètre qui entre en ligne de compte dans le fonctionnement d'une batterie.

Une variable d'état d'usure est définie lors d'un démarrage à froid dudit moteur thermique. Ainsi, dans ce cas, la température batterie est sensiblement égale à la température moteur, ce qui permet de s'affranchir du paramètre température moteur lors de l'évaluation du fonctionnement.

Une variable d'état nominale est définie lors d'un démarrage à froid dudit moteur thermique. Ainsi, dans ce cas, la température batterie est sensiblement égale à la température moteur, ce qui permet de s'affranchir du paramètre température moteur lors du calcul du profil de fonctionnement de la batterie.

Une variable d'état d'usure est définie lorsque la batterie est à l'état de charge maximale. Cela permet de s'affranchir de ce paramètre lors de l'évaluation du fonctionnement.

Une variable d'état nominale est définie lorsque la batterie est à l'état de charge maximale. Cela permet de s'affranchir de ce paramètre lors de l'évaluation du profil de fonctionnement.

Une fonction de la vitesse de rotation est une vitesse moyenne. Cela permet d'avoir une fonction simple à mettre en oeuvre.

La vitesse moyenne est déterminée pour une deuxième compression du moteur thermique. En effet, la deuxième compression est facile à détecter.

La vitesse moyenne est déterminée pour une troisième compression du moteur thermique. Cela permet d'augmenter la précision de l'évaluation.

Un état de fonctionnement déterminé de la batterie est d'alimenter la machine électrique tournante. Cela permet à la machine électrique tournante de démarrer le moteur thermique.

Un état de fonctionnement déterminé de la batterie est d'alimenter des consommateurs dudit véhicule. Cela permet de compléter l'alimentation par la machine électrique tournante si cette dernière débite un courant trop faible pour alimenter tous les consommateurs.

La machine électrique tournante est réversible. Ainsi, ledit procédé est effectif avec un alternateur-démarreur.

Une solution au problème technique posé consiste, selon un deuxième objet de la présente invention, en ce que le dispositif d'évaluation comporte :
- des moyens d'évaluation d'au moins une vitesse de rotation de ladite machine électrique tournante,
- des moyens d'établissement d'au moins une variable d'état d'usure selon une fonction de ladite vitesse de rotation, et
- des moyens de comparaison ladite au moins variable d'état d'usure à au moins une variable d'état nominale.

### Brève description des Figures

La Fig. 1 est un graphe représentant des étapes du procédé selon l'invention selon un mode de réalisation préféré non limitatif,
La Fig. 2 est un graphe représentant la puissance d'une batterie en fonction d'un état de charge,
La Fig. 3 est une courbe de vitesse d'une machine électrique tournante au démarrage en fonction du temps, utilisée lors du procédé de l'invention de la Fig. 1,
La Fig. 4 représente un premier graphe de valeurs nominales de la vitesse de rotation d'une machine électrique tournante, et de valeurs d'état d'usure calculées selon le procédé de l'invention de la Fig. 1, et
La Fig. 5 représente un deuxième graphe de valeurs nominales de la vitesse de rotation d'une machine électrique tournante, et de valeurs d'état d'usure calculées selon le procédé de l'invention de la Fig. 1.

### Description détaillée de modes de réalisation de l'invention.

Le procédé selon l'invention s'applique à un véhicule comportant une machine électrique tournante et au moins une unité de stockage d'énergie telle qu'une batterie. La machine électrique tournante est de tout type. C'est par exemple un démarreur électrique intégrant une commande électronique ou encore une machine réversible telle qu'un alternateur-démarreur appelé également alterno-démarreur.

Dans la suite de la description, on prendra comme exemple, un alterno-démarreur comme machine électrique tournante.

L'alterno-démarreur comporte un rotor et un stator. Il permet de transformer l'énergie mécanique en énergie électrique et vice versa. Ainsi, il permet de transformer un mouvement de rotation du rotor inducteur, entraîné par le moteur thermique du véhicule, en un courant électrique induit dans les bobinages du stator. Il constitue également un moteur électrique et permet d'entraîner en rotation, via l'arbre du rotor, le moteur thermique du véhicule. Ainsi, en mode alternateur ou générateur, l'alterno-démarreur charge notamment la batterie du véhicule tandis qu'en mode moteur l'alterno-démarreur entraîne le moteur thermique du véhicule automobile pour démarrer.

La batterie d'un véhicule automobile a pour fonction essentielle d'alimenter lors du mode moteur, l'alterno-démarreur pour démarrer le moteur thermique.

De plus, ladite batterie permet d'alimenter les consommateurs du véhicule tels que la climatisation, le chauffage, les essuie-glaces, l'autoradio, etc.... quand l'alterno-démarreur ne débite pas assez de courant pour le faire ou quand la clef de contact se trouve en mode +ACC.

En conséquence, pour savoir si les consommateurs ou encore l'alterno-démarreur sont bien alimentés de sorte qu'un démarrage se fasse sans problème, il est nécessaire de connaître l'état de fonctionnement de ladite batterie.

Comme décrit plus haut, la batterie comporte une résistance interne RINT. Lorsque la batterie vieillit, ladite résistance augmente. Lorsque la résistance augmente, la batterie fournit moins de puissance à l'alterno-démarreur pour démarrer le moteur thermique de sorte que la vitesse de rotation dudit alterno-démarreur est plus faible que lorsque la batterie est neuve par exemple, dans les même conditions de fonctionnement (état de charge, température batterie, ...). En effet, plus sa résistance interne est élevée, moins la batterie va fournir de courant à l'alterno-démarreur, et donc l'alterno-démarreur aura moins de courant pour entraîner le moteur thermique qui sera donc entraîné moins vite.

Ainsi, la vitesse de rotation VALT de l'alterno-démarreur est représentative de la résistance interne RINT de la batterie. On notera que la vitesse de rotation VALT (tour/min) de l'alterno-démarreur est en relation avec la vitesse de rotation VMOT (tour/min) du moteur selon un rapport de poulie (via un moyen de transmission telle qu'une courroie) qui est sensiblement égale à 3. L'ensemble poulie-courroie relie l'alterno-démarreur au moteur et permet à l'alterno-démarreur d'entraîner le moteur. Ainsi, VALT = VMOT*3.

Par ailleurs, on notera que la résistance interne RINT de la batterie dépend notamment de deux paramètres supplémentaires. La température batterie Tb et l'état de charge SOC de la batterie. En effet, plus il fait froid, plus la résistance interne RINT augmente. De plus, quand la température baisse, le moteur thermique est plus difficile à démarrer en raison de frottements qui augmentent dans le moteur à ces températures. De plus, plus l'état de charge SOC de la batterie diminue, plus la résistance interne RINT augmente. On rappellera que l'état de charge (en Ah) est représentative de l'énergie disponible de la batterie par rapport à l'énergie maximale effective de la batterie. On notera que l'énergie maximale diminue au cours du temps. Au départ, l'énergie maximale est égale à l'énergie nominale. Par la suite, au cours du temps, l'énergie maximale effective est inférieure à l'énergie nominale et ce en raison du processus de vieillissement de la batterie.

A cet effet, afin d'évaluer la capacité d'une batterie à répondre à un état de fonctionnement déterminé, on procède comme décrit ci-après en prenant en compte la vitesse de rotation VALT de l'alterno-démarreur.

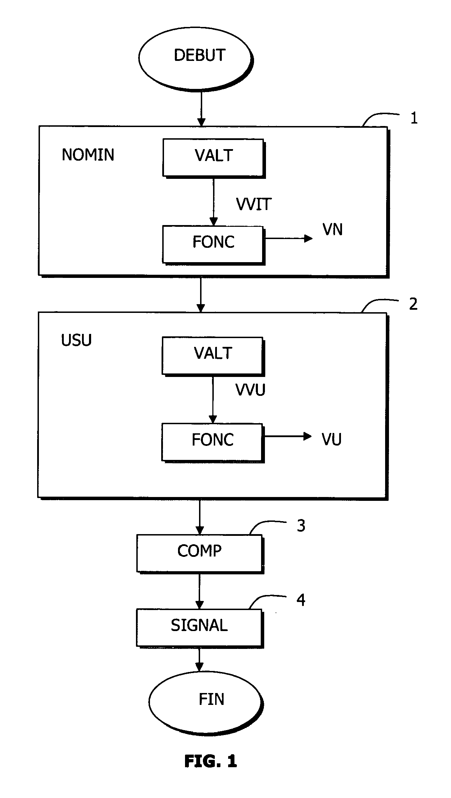

**Dans une première étape NOMIN),** on détermine un profil de fonctionnement de la batterie pendant une période de temps déterminée PDT1 selon les étapes suivantes comme indiqué à la Fig. 1. Le profil de fonctionnement est déterminé par au moins une variable d'état nominale VN de fonctionnement à un instant t donné pour une température Tb donnée de batterie et pour un état de charge SOC de batterie donné. On notera que la température Tb batterie correspond sensiblement à la température Te extérieure. La variable d'état nominale VN de fonctionnement est déterminée selon la vitesse de rotation VALT de l'alterno-démarreur, soit de façon plus précise selon la vitesse rotor.

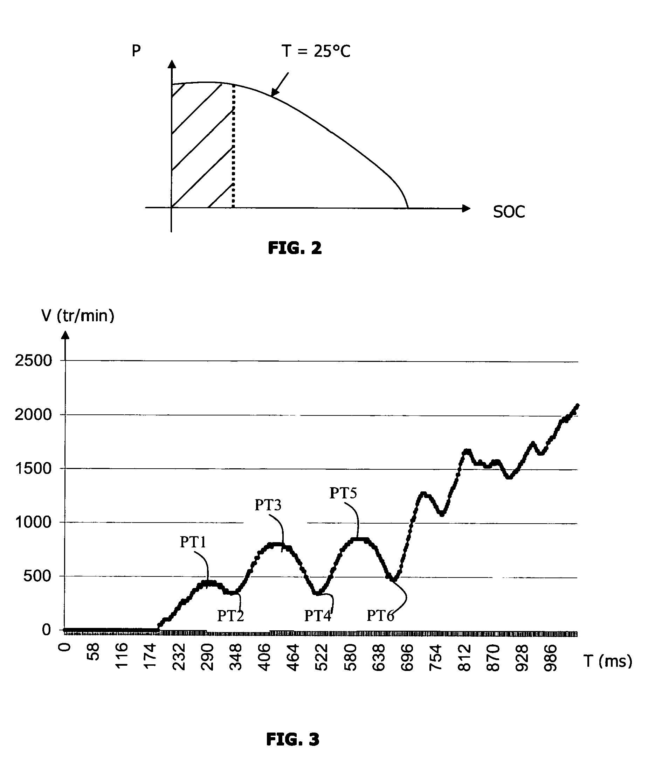

Selon un mode de réalisation préférentiel non limitatif, l'état de charge SOC de la batterie est l'état de charge maximale de ladite batterie. En effet, une batterie en particulier une batterie au plomb comporte une durée de vie optimale lorsqu'elle est bien chargée. De plus, en prenant un SOC maximum, on évite de déterminer pour chaque variable d'état nominale un SOC. Ainsi, on s'affranchit d'un paramètre supplémentaire. Par SOC maximum, on entend la zone hachurée définie sur la Fig.2 dans laquelle, à température ambiante (par exemple 25°C), la puissance P délivrée par la batterie est constante et maximum.

De plus, selon un mode de réalisation préférentiel non limitatif, une variable d'état nominale VN est définie lors d'un démarrage à froid du moteur thermique. Ainsi, lors d'un démarrage à froid, la température batterie Tb est équivalente à la température Tm du moteur. Ce quatrième paramètre Tm entre en ligne de compte dans la définition du profil de fonctionnement nominal. Afin d'éviter de devoir mesurer la température moteur Tm pour chaque variable d'état nominale VN, on s'affranchit ainsi d'un quatrième paramètre à mesurer. En effet, lors d'un démarrage à chaud, la température moteur Tm n'est pas égale à la température batterie Tb. En général, plus le moteur est chaud, plus il est facile à entraîner. On notera qu'on entend par démarrage à froid, un démarrage (c'est-à-dire après un arrêt prolongé, soit moteur coupé et électronique en veille et ou coupée) effectué par la clef ou carte de contact via un démarreur ou l'alterno-démarreur. Il ne comprend pas les redémarrages automatiques effectués par l'alterno-démarreur après une phase d'arrêt automatique effectuée par ledit alterno-démarreur, ledit alterno-démarreur comportant la fonction arrêt/redémarrage automatique couramment appelé en anglais « stop/start».

On notera que l'on vérifie préférentiellement si la température Tb batterie est égale à la température Tm moteur comme décrit précédemment. Cette vérification peut s'effectuer à tout moment, c'est-à-dire :
- soit avant les étapes et sous-étapes décrites ci-après ; dans ce cas, si Tb = Tm, alors on effectue les sous-étapes suivantes. Si non, on n'effectue pas les mesures.
- soit pendant l'une quelconque des étapes ou sous-étapes décrites ci-après ; dans ce cas, si Tb = Tm, alors on effectue l'étape ou la sous-étape d'après, sinon on ne tient pas compte des mesures déjà effectuées.

**Selon une première sous-étape VALT)**, lors d'un démarrage à froid, à un instant donné t1, on mesure la vitesse de rotation VALT (en tour/minute) de l'alterno-démarreur. A cet instant donné est associé une température Tb1 batterie que l'on mesure également. On réitère l'opération de manière à obtenir une série de points de vitesse formant un vecteur VVIT.

Pour les relevés de ladite vitesse de rotation VALT, on utilise un capteur approprié connu de l'homme du métier, par exemple des capteurs de position. On notera que de façon connue de l'homme du métier, il existe en général trois capteurs de position situés dans l'alterno-démarreur.

**Dans une deuxième sous-étape FONC)**, on applique une fonction déterminée FONC à ce vecteur VVIT de vitesses de rotation mesurée VALT.
Dans un mode de réalisation préférentiel non limitatif, cette fonction FONC est une valeur moyenne VM de la vitesse VALT. Le calcul de la valeur moyenne VM se fait préférentiellement au premier démarrage du moteur, c'est-à-dire démarrage à froid, et ce pour les deuxième et troisième compressions du moteur thermique.

Le calcul de la vitesse moyenne VM se fait de la manière suivante.

On détermine la position des compressions au niveau des cylindres du moteur thermique en fonction de ladite vitesse de rotation VALT pour chaque point du vecteur vitesse VVIT, puis dans un deuxième temps, on calcule la vitesse moyenne VM.

On notera qu'une compression est déterminée par deux valeurs minimales et une valeur maximale. On recherche ainsi ces valeurs minimales et maximales pour chaque compression.

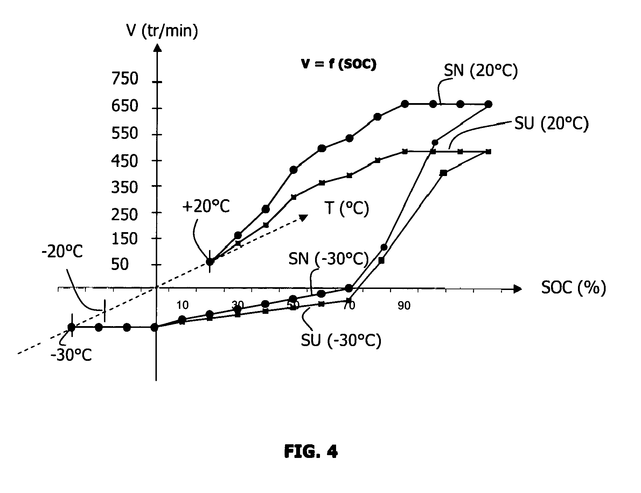

La détermination des compressions se fait de la manière suivante.
1) On part d'une vitesse nulle (moteur arrêté).
   On enclenche la lecture de la vitesse de rotation VALT après un démarrage à froid. On notera qu'il existe un temps de latence entre une demande de démarrage et le démarrage effectif du moteur, tel qu'on peut le voir sur la Fig. 3.
   Préférentiellement, la lecture se fait en permanence selon une résolution de 25 tours/min et la fréquence d'acquisition est préférentiellement sensiblement égale à 2ms.
2) Lorsque la vitesse augmente, elle est considérée comme la nouvelle valeur maximale de référence.
3) Lorsque la vitesse diminue, on attend la confirmation de cette diminution. Préférentiellement, la confirmation est faite pour un écart de 75 tr/min. Autrement dit, on attend qu'il y ait une différence de lecture de trois pas pour être certain qu'il n'existe pas d'erreur de lecture.
4) Si l'écart est confirmé, la valeur maximale de référence acquise précédemment (lors de l'étape 2) est mémorisée comme valeur maximale pour la compression considérée (ici la première). La valeur actuelle lue devient la nouvelle valeur minimale de référence.
5) Lorsque la vitesse augmente (à nouveau), on attend la confirmation de cette augmentation (écart de 75 tr/min).
6) Si l'écart est confirmé, la valeur minimale de référence acquise précédemment est mémorisée (lors de l'étape 4) comme valeur minimale pour la compression considérée (toujours la première). Ainsi, on définit la première compression.
7) La valeur actuelle lue devient la nouvelle valeur maximale de référence, ceci pour la compression suivante (ici la deuxième).
8) On reproduit les étapes 2) à 7) pour les deuxième et troisième compressions.

La Fig. 3 représente la courbe de vitesse VALT de l'alterno-démarreur au démarrage.

On remarque que la première compression symbolisée par le premier point PT1 (valeur maximale) et le deuxième point 2 PT2 (valeur minimale), ainsi que les 2^{ème} (troisième et quatrième points PT3, PT4) et 3^{ème} (cinquième et sixième points 5 et 6, PT5, PT6) compressions.

Un exemple d'expérimentation non limitatif a donné le relevé des points remarquables suivant.
- PT1 (480 tr/min positionné à 290 ms)
- PT2 (425 tr/min positionné à 348 ms)
- PT3 (850 tr/min positionné à 420 ms)
- PT4 (475 tr/min positionné à 520 ms)
- PT5 (925 tr/min positionné à 592 ms)
- PT6 (498 tr/min positionné à 658 ms)

Ainsi, la détermination de la vitesse moyenne VM se fait en effectuant la somme des relevés du vecteur de vitesses de rotation VVALT, en partant de la valeur minimale PT2 de la première compression et en arrivant à la valeur minimale PT6 de la troisième compression. On fait ainsi une moyenne de toutes les acquisitions effectuées entre ces deux points PT2 et PT6. On remarquera que l'on ne prend pas en compte le premier point PT1, car celui-ci peut ne pas être très visible en raison de la manière dont s'arrête le moteur thermique.

Ainsi, le calcul d'une variable d'état nominale est effectué.

Dans un mode de réalisation préférentiel non limitatif, on calcule un vecteur de variables d'état nominales lors de la période de temps déterminée PDT1, lesdites variables étant calculées selon les sous-étapes décrites précédemment lors d'un démarrage à froid.

Par exemple cette période de temps déterminée PDT1 peut être d'une durée de un an dans ce cas ou encore un nombre de kilomètres fixé à 20 000km par exemple. Cela correspond sensiblement à une batterie neuve.

Ainsi, on aura plusieurs valeurs de variables d'état nominales à des temps différents t pour des températures différentes Tb.

Ainsi, pour un premier temps t1, on aura une première variable d'état nominale VN1 à laquelle correspondra une température Tb1.

Pour un deuxième temps t2, on aura une deuxième variable d'état nominale VN2 à laquelle correspondra une température Tb2.

Pour un troisième temps t3, on aura une troisième variable d'état nominale VN3 à laquelle correspondra une température Tb3.

Dans une premier mode de réalisation non limitatif, lesdites variables d'état VN sont mémorisées en fonction des temps t, soit par exemple une fois par jour, pendant un an.

Dans un deuxième mode de réalisation non limitatif, lesdites variables d'état VN sont mémorisées en fonction des températures Tb, soit par exemple selon des plages de valeurs, par exemple comprises entre 0°C et 5°C. Ainsi, si par exemple quatre variables d'états VN1, VN2, VN3 et VN4 ont été calculées respectivement pour des températures Tb1 = 0°C, Tb2 = 1 °C, Tb3 = 3°C, et Tb4 = 8°C, on calculera la moyenne des trois premières variables d'état pour ne mémoriser qu'une seule valeur. En fin de compte, on mémorisera uniquement deux valeurs, la moyenne de VN1 à VN3, et VN4.

Ainsi, en calculant un vecteur de variables d'état nominales, on obtient une surface nominale SN telle que représentée dans l'exemple non limitatif à la Fig. 4. Sur l'axe 0y, est représentée la vitesse V (en tour/min), sur l'axe 0z, la température (°C) et sur l'axe 0x le SOC (en % en général). Cette surface SN représente un profil type de fonctionnement de la batterie. Dans l'exemple, SN représente le fonctionnement de la batterie entre 20°C et -30°C.

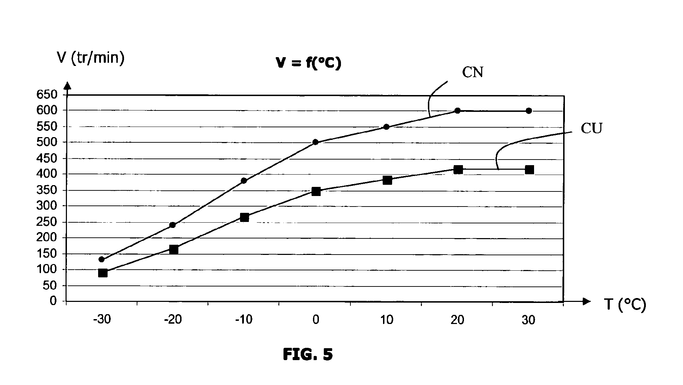

Comme décrit précédemment, le calcul étant effectué préférentiellement lors d'un état de charge maximal SOC, on s'affranchit de ce troisième paramètre. En conséquence, cette surface SN devient une courbe CN telle qu'illustrée sur l'exemple non limitatif de la Fig. 5.

**Dans une deuxième étape USU)**, on détermine une variable d'état d'usure VU, préférentiellement un vecteur VVU de variables d'état d'usure, selon les mêmes sous-étapes décrites précédemment pour un vecteur de variables d'état nominales, et ce lors d'une première période de temps PDT2 postérieure à la période de temps PDT1.

De la même manière, selon un mode de réalisation préférentiel non limitatif, l'état de charge SOC de la batterie est l'état de charge maximale de ladite batterie pour le calcul dudit vecteur d'usure VVU.

De plus, selon un mode de réalisation préférentiel non limitatif, une variable d'état d'usure VU est définie lors d'un démarrage à froid du moteur thermique.

On obtient de la même manière une surface d'usure SU telle que représentée dans l'exemple non limitatif à la Fig. 4. Sur l'axe 0y, est représentée la vitesse V (en tour/min), sur l'axe 0z, la température (°C) et sur l'axe 0x le SOC (en %). Cette surface SU représente le fonctionnement de la batterie lors de la période de temps PDT2. Dans l'exemple, SU représente le fonctionnement de la batterie entre 20°C et -30°C lors de la période de temps PDT2. On remarquera que sur la Fig. 4, la surface d'usure SU se trouve en dessous de la surface nominale SN.

Comme décrit précédemment, le calcul étant effectué préférentiellement lors d'un état de charge maximal SOC, on s'affranchit de ce troisième paramètre. En conséquence, cette surface SU devient une courbe CU telle qu'illustrée sur l'exemple non limitatif de la Fig. 5.

**Dans une troisième COMP)**, on compare le fonctionnement de la batterie au profil de fonctionnement nominal déterminé, c'est-à-dire qu'on compare chaque valeur de variable d'usure VU calculée à une température donnée qui se trouve sur la courbe d'usure CU à la courbe nominale CN, et ce au fur et à mesure du calcul d'une variable d'état d'usure.

Ainsi, préférentiellement, pour le fonctionnement déterminé de l'alimentation de l'alterno-démarreur, on utilise la fonction suivante.

Dans un premier exemple non limitatif, le rapport entre le vecteur VU et le vecteur VN se situe dans une plage de valeurs comprises entre 0,5 et 0,75.

Préférentiellement, le rapport entre le vecteur VU et le vecteur VN est une valeur qui est fixée à 0,7 : VU = 0,7VN. Ainsi, si le rapport est inférieur à 0,7, on pourra conclure que la batterie est usée et qu'il faut la changer.

On notera qu'il est aussi possible d'utiliser une valeur du rapport entre le vecteur VU et le vecteur VN variable en fonction de la température.

Ainsi, on évalue la capacité de la batterie selon une fonction basée sur la comparaison entre une variable d'état d'usure et une variable nominale, ladite fonction dépendant d'un fonctionnement déterminé tel que l'alimentation de l'alterno-démarreur pour démarrer.

**Dans une quatrième étape SIGNAL),** on envoie un signal de contrôle SIGN à un organe de gestion du véhicule, ledit signal SIGN étant représentatif de ladite évaluation. L'organe de gestion du véhicule peut être le contrôle moteur CMU bien connu de l'homme du métier, ou encore le boîtier de contrôle de l'alterno-démarreur.

Ainsi, selon la nature dudit signal SIGN, le conducteur du véhicule sera prévenu, par exemple par un signal sonore ou lumineux, s'il doit par exemple changer sa batterie avant de tomber en panne ou encore s'il lui est interdit de faire un arrêt/redémarrage automatique au moyen de l'alterno-démarreur. En effet, si la batterie est trop usée pour permettre de démarrer ou redémarrer le moteur thermique, il serait dangereux de permettre une phase d'arrêt automatique à un feu rouge par exemple.

On notera que l'ensemble des opérations effectuées lors de cette évaluation notamment les mémorisations des valeurs de variables d'état d'usure ou nominale, ou encore le calcul desdites variables, sont préférentiellement effectuées par un boîtier de contrôle BMS de la batterie couramment appelé dans le langage anglo-saxon « Battery Management System », ledit système comportant de façon conventionnelle une mémoire et un microprocesseur.

Ainsi, le procédé d'évaluation selon l'invention présente les avantages suivants.

Premièrement, il permet de s'affranchir de capteurs de tension qui sont coûteux et peuvent présenter des problèmes électromagnétiques.

Deuxièmement, il permet d'évaluer le fonctionnement d'une batterie sans pour autant avoir accès au contrôle moteur CMU. Cela évite d'avoir une interface supplémentaire qui accède à des informations du CMU.

En effet, dans le cas du contrôle moteur, ce dernier doit aller chercher les informations de tension directement sur la batterie et donc passer par une connectique batterie et un câblage batterie qui pose de problèmes de temps réel et de protocole de communication. De plus, le débit sur la liaison protocolaire du CMU ne permet pas d'avoir une précision d'acquisition de 2ms.

Dans le cas de l'invention, on accède à une seule information, la vitesse rotor et ce directement sur le boîtier de contrôle de la machine, ici l'alterno-démarreur, ledit alterno-démarreur étant relié audit moteur thermique par une courroie ou directement sur l'arbre du moteur. On s'affranchit ainsi des résistances internes des câbles reliant le moteur thermique et l'alterno-démarreur à la batterie, lesdites résistances pouvant parasiter le calcul d'évaluation.

Troisièmement, il permet d'obtenir une meilleure précision dans ladite évaluation, en effectuant ladite évaluation à partir du nombre de tours machine au lieu du nombre de tours moteur, car il n'existe qu'un seul capteur de vitesse pour le moteur alors que pour l'alterno-démarreur, il existe trois capteurs de vitesse de sorte que l'évaluation par vitesse machine est plus précise que l'évaluation par vitesse moteur. De plus, le rapport de la poulie est multiplié par trois ce qui permet d'augmenter la précision de l'acquisition.

## Revendications

1. Procédé d'évaluation de la capacité d'une unité de stockage pour véhicule automobile à répondre à un fonctionnement déterminé, ledit véhicule comprenant un moteur thermique, une machine électrique tournante destinée à entraîner ledit moteur thermique, ***caractérisé en ce qu'**il* comprend les étapes de, lors d'une première période de temps (PDT2) déterminée :
- évaluer au moins une vitesse de rotation (VALT) de ladite machine électrique tournante (ALT),
- établir au moins une variable d'état d'usure (VU) selon une fonction (FONC) de ladite vitesse de rotation (VALT), et
- comparer ladite au moins variable d'état d'usure (VU) à au moins une variable d'état nominale (VN).

2. Procédé selon la revendication 1, selon lequel ladite variable d'état nominale (VN) est définie lors d'une période de temps (PDT1) antérieure à la première période de temps (PDT2).

3. Procédé selon l'une des revendications 1 ou 2, selon lequel il comporte en outre les étapes de :
- évaluer la capacité de ladite unité de stockage selon une fonction basée sur la comparaison entre une variable d'état d'usure et une variable d'état nominale, ladite fonction dépendant dudit fonctionnement déterminé, et
- envoyer un signal de contrôle (SIGN) à un organe de gestion du véhicule représentatif de ladite évaluation.

4. Procédé selon l'une des revendications 1 à 3, selon lequel un vecteur de variables d'état d'usure (VU) est défini selon les étapes dudit procédé.

5. Procédé selon l'une quelconque des revendications précédentes, selon lequel un vecteur de vitesses de rotation (VALT) est défini, lesdites vitesses étant déterminées en fonction d'une température (Tb) de ladite unité de stockage , ladite température évoluant lors d'une période de temps (PDT).

6. Procédé selon l'une quelconque des revendications précédentes, selon lequel une variable d'état d'usure (VU) est définie lors d'un démarrage à froid dudit moteur thermique.

7. Procédé selon l'une quelconque des revendications précédentes, selon lequel une variable d'état nominale (VN) est définie lors d'un démarrage à froid dudit moteur thermique.

8. Procédé selon l'une quelconque des revendications précédentes, selon lequel ladite variable d'état d'usure (VU) est définie lorsque la unité de stockage est à l'état de charge maximale.

9. Procédé selon l'une quelconque des revendications précédentes, selon lequel une variable d'état nominale (VN) est définie lorsque ladite unité de stockage est à l'état de charge maximale.

10. Procédé selon l'une quelconque des revendications précédentes, selon lequel une fonction (FONC) de la vitesse de rotation est une vitesse moyenne (VM).

11. Procédé selon la revendication 10, selon lequel la vitesse moyenne (VM) est déterminée pour une deuxième compression du moteur thermique.

12. Procédé selon l'une des revendications 10 ou 11, selon lequel la vitesse moyenne (VM) est déterminée pour une troisième compression du moteur thermique.

13. Procédé selon l'une quelconque des revendications précédentes, selon lequel un état de fonctionnement déterminé de ladite unité de stockage est d'alimenter la machine électrique tournante.

14. Procédé selon l'une quelconque des revendications précédentes, selon lequel un état de fonctionnement déterminé de ladite unité de stockage est d'alimenter des consommateurs dudit véhicule.

15. Procédé selon l'une quelconque des revendications précédentes, selon lequel la machine électrique tournante est réversible.

16. Dispositif d'évaluation de la capacité d'une unité de stockage pour véhicule automobile à répondre à un fonctionnement déterminé, ledit véhicule comprenant un moteur thermique, une machine électrique tournante destinée à entraîner ledit moteur thermique, **caractérisé en ce qu'**il comporte :
- des moyens d'évaluation d'au moins une vitesse de rotation (VALT) de ladite machine électrique tournante,
- des moyens d'établissement d'au moins une variable d'état d'usure (VU) selon une fonction de ladite vitesse de rotation, et
- des moyens de comparaison de ladite au moins variable d'état d'usure (VU) à au moins une variable d'état nominale (VN).
